# EUROPÄISCHE PATENTANMELDUNG

(11) **EP 3 168 935 A1**
(43) Veröffentlichungstag der Anmeldung: **17.05.2017**
(21) Anmeldenummer: 15194142.4
(22) Anmeldetag: 11.11.2015
(51) Int. Cl.: H01R 11/28, G01R 31/36, G01R 1/20

(54) **ANSCHLUSSEINRICHTUNG UND BATTERIEANORDNUNG**

(71) Anmelder: HOPPECKE Batterien GmbH & Co. KG., 59929 Brilon (DE)
(72) Erfinder: Kesper, Heinrich, 34508 Willingen (DE)
(74) Vertreter: Stenger Watzke Ring

(57) **Zusammenfassung**

Die Erfindung betrifft eine Anschlusseinrichtung (17) für eine Batterie zur Zwischenschaltung zwischen einen Batterieanschluss und einen an der Batterie angeschlossenen Verbraucher, aufweisend ein elektrisch leitend ausgebildetes erstes Bauteil (18), ein elektrisch leitend ausgebildetes zweites Bauteil (19), wenigstens ein elektrisch leitend ausgebildeter Nebenwiderstand (25) und ein elektrisch isolierend ausgebildetes Verbindungselement (20), wobei die Bauteile (18, 19) unter Zwischenordnung des Verbindungselements (20) voneinander beabstandet angeordnet sind, wobei das Verbindungselement (20) zur mechanischen Verbindung der Bauteile (18, 19) mit dem ersten (18) und dem zweiten Bauteil (19) in Kontakt steht und wobei der Nebenwiderstand (25) zur elektrischen Verbindung der Bauteile (18, 19) mit dem ersten (18) und dem zweiten Bauteil (19) in Kontakt steht.

## Beschreibung

Die Erfindung betrifft eine Anschlusseinrichtung für eine Batterie zur Zwischenschaltung zwischen einen Batterieanschluss und einen an die Batterie angeschlossenen Verbraucher. Ferner betrifft die Erfindung eine Batterieanordnung aufweisend eine Anschlusseinrichtung.

Aufgrund der technologischen und wirtschaftlichen Entwicklungen der letzten Jahre nimmt der Anteil an batteriegestützten, insbesondere akkumulatorgestützten, elektrischen oder elektronischen Anwendungen gegenüber herkömmlichen Anwendungen, welche klassischerweise aus dem Stromnetz gespeist werden, stetig zu. Auch aus ökologischen Gründen werden derzeit Überlegungen angestellt, nicht länger Batterien als Verbrauchsgegenstand zu verkaufen, sondern leihweise zur Verfügung zu stellen und Gebühren für den aus der Batterie entnommenen Strom ähnlich dem Abrechnungsmodus für Strom aus dem Stromnetz zu erheben. Hierzu bedarf es unter anderem einer verlässlichen Möglichkeit zur Bestimmung der der Batterie entnommenen Strommenge. Eine Strommenge im Sinne der Erfindung bezeichnet dabei eine der Batterie entnommene elektrische Energie.

Es wurden im Stand der Technik daher Versuche unternommen, Messeinrichtungen unmittelbar an die Anschlusspole einer Batterie anzuschließen. Diese Methode hat sich allerdings als für Batterien vollkommen ungeeignet herausgestellt. Beim Betrieb einer Batterie erhitzt sich er Anschlusspol aufgrund seines materialimmanenten elektrischen Widerstands in Abhängigkeit der Stromabgabe. Klassischerweise bestehen die Anschlusspole von Batterien zumindesdt teilweise aus Kupfer. Kupfer weist einen vergleichsweise großen Widerstands-Temperaturkoeffizienten auf, weshalb die Strommessung unmittelbar am Anschlusspol in Abhängigkeit der Temperatur vergleichsweise starken Schwankungen unterworfen sind. Eine Strommessung, die unabhängig von der Temperatur reproduzierbare Ergebnisse liefert, ist auf diesem Wege nicht zu realisieren.

Die allgemeine Problematik der Temperaturabhängigkeit von Strommessungen ist aus dem Stand der Technik dem Grunde nach bekannt. Für Messungen im bundesweiten statischen Stromnetz, z.B. bei Stromzählern in der Industrie oder in Wohnhäusern und dergleichen werden besondere Anschlusseinrichtungen eingesetzt, die eine im Wesentlichen temperaturunabhängige Strommessung gestatten. Eine solche elektrische Baugruppe besteht im Wesentlichen aus zwei elektrischen Kontakten, die über einen Nebenwiderstand, insbesondere einen Shunt, mit geringem linearen Widerstands-Temperaturkoeffizienten miteinander mechanisch und elektrisch verbunden sind. Eine Messeinrichtung ist dabei mit dem Nebenwiderstand elektrisch verbunden. Messgröße ist hierbei der Spannungsabfall des durch den Nebenwiderstand fließenden Stromes.

Es hat sich herausgestellt, dass solche herkömmlichen Anschlusseinrichtungen für die Strommessung an Batterien ungeeignet sind. Dies insbesondere deshalb, da Batterien in der Regel unmittelbar in die mit Strom zu versorgende Vorrichtung eingebaut werden müssen. Sie und damit auch die Anschlusseinrichtungen sind daher einer vergleichsweise hohen mechanischen Belastung ausgesetzt. Deutlich wird dies am Beispiel einer Traktionsbatterie, welche in Elektrofahrzeugen eingesetzt und dort insbesondere für den Antrieb genutzt wird. Eine solche Traktionsbatterie besteht in der Regel aus einer Vielzahl von Zellen, die elektrisch miteinander verbunden sind. Die Verbindung wird klassischerweise über Verbinder in Form elektrisch leitender Kupferplättchen oder -kabel hergestellt, welche jeweils gleichartige Anschlusspole der einzelnen Zellen miteinander verbinden.

Um zu ermitteln, wieviel Strom jeder Zelle entnommen wird, muss jeder Zelle eine Anschlusseinrichtung zugeordnet werden. Erste Versuche, den Verbinder durch eine herkömmliche Anschlusseinrichtung zu ersetzen bzw. eine herkömmliche Anschlusseinrichtung in den Verbinder zu integrieren sind allerdings gescheitert. Beim Betrieb z.B. eines Fahrzeugs, kann es je nach befahrenem Untergrund zur Erschütterung der Batterie kommen, was dazu führt, dass sich einzelne Zellen und damit auch die Verbinder relativ zueinander bewegen. Es hat sich herausgestellt, dass herkömmliche Anschlusseinrichtungen diesen mechanischen Belastungen nicht standhalten können und nach kürzester Zeit zerstört werden.

Eine technisch reproduzierbare Strommessung an mechanisch beanspruchten Batterien ist daher bislang nicht möglich, obgleich hieran ein vitales industrielles Interesse besteht.

Es ist daher die **Aufgabe** der Erfindung, eine Anschlusseinrichtung und eine Batterieanordnung bereitzustellen, die reproduzierbare Strommessungen an mechanisch beanspruchten Batterien über einen vergleichsweise langen Zeitraum erlaubt.

Zur **Lösung** der erfindungsgemäßen Aufgabe wird eine Anschlusseinrichtung für eine Batterie zur Zwischenschaltung zwischen einen Batterieanschluss und einen an der Batterie angeschlossenen Verbraucher vorgeschlagen, aufweisend ein elektrisch leitend ausgebildetes erstes Bauteil, ein elektrisch leitend ausgebildetes zweites Bauteil, wenigstens ein elektrisch leitend ausgebildeter Nebenwiderstand und ein elektrisch isolierend ausgebildetes Verbindungselement, wobei die Bauteile unter Zwischenordnung des Verbindungselements voneinander beabstandet angeordnet sind, wobei das Verbindungselement zur mechanischen Verbindung der Bauteile mit dem ersten und dem zweiten Bauteil in Kontakt steht und wobei der Nebenwiderstand zur elektrischen Verbindung der Bauteile mit dem ersten und dem zweiten Bauteil in Kontakt steht.

Die erfindungsgemäße Anschlusseinrichtung ist gegenüber unsachgemäßer Krafteinwirkung nahezu unempfindlich. Dieser Vorteil ergibt sich aus der erfindungsgemäßen Anordnung des Verbindungselements, welches für eine mechanische Verbindung der Bauteile sorgt. Die Wirkung der Zwischenordnung liegt einerseits in einer mechanischen Stabilisierung der Bauteile und des Nebenwiderstands und andererseits in der Ableitung von unsachgemäß gegen den Nebenwiderstand gerichteter Kraft. So können sich die Bauteile im Falle einer auf die Bauteile gerichteten Krafteinwirkung in Richtung des Verbindungselements in vorteilhafter Weise auf dem Verbindungselement abstützen. Hierdurch werden insbesondere die Kontaktstellen zwischen Bauteilen und Nebenwiderstand mechanisch entlastet. Die erfindungsgemäße Anschlusseinrichtung ist damit weitestgehend unempfindlich gegenüber Krafteinwirkungen aufgrund relativer Bewegungen zwischen Batterie und Verbraucher freigestellt. Sie ist damit auch gegenüber solchen mechanischen Beanspruchungen stabil, die zur Zerstörung einer aus dem Stand der Technik bekannten Anschlusseinrichtung führen würde.

Erfindungsgemäß ist das Verbindungselement elektrisch isolierend ausgebildet. Vorzugsweise ist das Verbindungselement zu diesem Zweck aus elektrisch isolierendem Material ausgebildet. Hierfür kommen insbesondere elektrisch isolierende Polymere in Betracht. Vorzugsweise ein synthetischer Kunststoff. Der Kunststoff ist dabei insbesondere aus einem thermoplastischen Elastomer (TPE) gebildet. Auf diese Weise wird einerseits ein mechanisch vergleichsweise widerstandsfähiges Verbindungselement bereitgestellt und andererseits der Produktionsaufwand vergleichsweise gering gehalten. Ferner wird auf diesem Wege ein Verbindungselement bereitgestellt, das über seine gesamte Raumerstreckung die gleichen Materialeigenschaften bietet. Alternativ kann das Verbindungselement aus zwei oder mehreren elektrisch isolierenden Materialen gebildet sein. Diese können im Verbindungselement homogen verteilt oder getrennt voneinander, insbesondere in separaten Schichten, vorliegen. Dies bietet den Vorteil eine hinsichtlich ihrer mechanischen Eigenschaften optimierte Anschlusseinrichtung für unterschiedlichste Anwendungsbereiche und Batterietypen bereitstellen zu können. Vorzugsweise entspricht der Umfang des Verbindungselements dem Umfang der Bauteile. Hierdurch wird eine optimale mechanische Abstützung der Bauteile durch das Verbindungselement erreicht. Ferner wird eine Berührung der Bauteile in Folge unsachgemäßer Krafteinwirkung vollständig verhindert, wodurch die Gefahr eines elektrischen Kurzschlusses unter Umgehung des Nebenwiderstands in vorteilhafter Weise vermieden wird.

Gemäß einem bevorzugten Merkmale der Erfindung ist das Verbindungselement als Spritzgussteil ausgebildet. Hierdurch kann insbesondere der Herstellungsaufwand des Verbindungselements im besonderen und der Anschlusseinrichtung im allgemeinen gesenkt werden. Hierbei wird ein Zwischenerzeugnis bestehend aus dem ersten und zweiten Bauteil, und dem wenigstens einen Nebenwiderstand in eine geeignete Gussform eingebracht. Anschließend wird eine Gussmasse in die Gussform eingespritzt. Das resultierende Verbindungselement füllt entsprechend sämtliche vom Zwischenerzeugnis bereitgestellten Volumenräume aus. Auf diesem Wege kann eine besonders stabile mechanische Verbindung zwischen Verbindungselement, erstem und zweitem Bauteil sowie dem Nebenwiderstand realisiert werden.

Erfindungsgemäß sind die Bauteile elektrisch leitend ausgebildet. Vorzugsweise sind die Bauteile zu diesem Zweck aus elektrisch leitendem Material gebildet. Bevorzugt handelt es sich bei diesem Material um ein metallisches Material mit hoher elektrischer Leitfähigkeit. Vorzugsweise ist dies Kupfer. Alternativ können die Bauteile auch aus einem nicht oder vergleichsweise schlecht elektrisch leitendem Basismaterial gebildet und mit einem Material mit hoher elektrischer Leitfähigkeit beschichtet sein. Insbesondere kann das Basismaterial dabei aus Kunststoff gebildet sein. Hierdurch können die Bauteile mittels üblicher Verfahren als Spritzgussteil hergestellt und anschließend beschichtet werden. Das unbeschichtete Bauteil ist damit der Massenproduktion zugänglich und kann als Fertigbauteil bereitgestellt werden, was vorteilhafterweise zu einer Reduzierung des Produktionsaufwand des Nebenwiderstands insgesamt führt. Ferner kann auf diesem Wege das Gewicht des Nebenwiderstands reduziert werden, was hinsichtlich solcher Anwendungen von Vorteil ist, bei denen ein hohes Gewicht von Nachteil ist. Dies betrifft insbesondere Anwendungen in der Fahrzeug- sowie Luft- und Raumfahrtindustrie, bei denen ein hohes Gewicht gleichzeitig zu einem erhöhten Kraftstoffverbrauch und erhöhtem Verschleiß führt. Diese nachteiligen Effekte können durch diese Ausgestaltung der Erfindung in vorteilhafter Weise reduziert werden.

Gemäß einem bevorzugten Merkmal der Erfindung sind die Bauteile flächig ausgebildet. Sie stellen demnach wenigstens zwei einander gegenüberliegende Außenflächen zur Kontaktierung mit dem Verbindungselement und dem wenigstens einen Nebenwiderstand bereit. Vorzugsweise sind die Bauteile dabei als Ringteile ausgebildet. Hierbei kann es vorgesehen sein, das erste Bauteil, das zweite Bauteil oder beide Bauteile jeweils als Ringteil auszubilden. Ein Ringteil stellt hierbei ein vorzugsweise zentrales Loch bereit, welches der Anordnung der Anschlusseinrichtung an der Batterie dient.

Gemäß einer bevorzugten Ausgestaltung der Erfindung weisen die Bauteile erste Ausnehmungen auf. Die ersten Ausnehmungen stellen dabei einen Volumenraum zur teilweisen Aufnahme des Nebenwiderstands zur Herstellung einer elektrisch leitenden Verbindung zwischen dem Nebenwiderstand und den Bauteilen bereit. Die ersten Ausnehmungen sind in der Aufsicht vorzugsweise kreisförmig ausgebildet. Vorzugsweise sind die ersten Ausnehmungen des ersten und des zweiten Bauteils hinsichtlich ihrer Positionierung miteinander korrespondierend in dem jeweiligen Bauteil angeordnet. Vorzugsweise weisen die ersten Ausnehmungen einen ersten Abschnitt und einen zweiten Abschnitt auf. Der erste Abschnitt weist dabei vorzugsweise einen größeren Innendurchmesser auf als der zweite Abschnitt. Der erste Abschnitt und der zweite Abschnitt sind vorzugsweise in Tiefenrichtung des Bauteils koaxial übereinander angeordnet. Vorzugsweise stellt der zweite Abschnitt erstabschnittseitig durch seinen im Vergleich zum ersten Abschnitt geringeren Innendurchmesser eine Kontaktfläche zur Kontaktierung des Nebenwiderstands bereit.

Gemäß einer bevorzugten Ausgestaltung der Erfindung ist der wenigstens eine Nebenwiderstand in das Verbindungselement eingebettet. hierdurch sind die Kontaktstellen zwischen Bauteilen und Nebenwiderstand durch die Einbettung in den Nebenwiderstands gegenüber einer in Richtung der Flächenerstreckung der Bauteile gerichteten Krafteinwirkung geschützt. Die Kraft wirkt hierdurch unmittelbar auf das Verbindungselement, aber nur mittelbar auf den Nebenwiderstand. Der überwiegende Teil der einwirkenden Kraft wird daher vom Verbindungselement absorbiert. Die mittelbar auf den Nebenwiderstand und die Kontaktstellen zwischen Nebenwiderstand und Bauteilen wirkende Kraft wird derart abgeschwächt, dass eine Beschädigung des Nebenwiderstands in vorteilhafter Weise verhindert wird.

Gemäß einer bevorzugten Ausgestaltung der Erfindung ist der Nebenwiderstand aus einer Legierung gebildet. Vorzugsweise besteht die Legierung aus wenigstens zwei Metallen der Gruppe Kupfer, Mangan, Aluminium und Nickel. Besonders bevorzugt sind dabei Legierungen der Zusammensetzung Cu₇₁Mn₂₅Al₄, Cu₈₄Mn₁₂Ni₄ oder Cu₅₅Ni₄₄Mn₁. Diese Legierungen zeichnen sich einerseits durch einen über weite Temperarturbereiche annähernd konstanten spezifischen Widerstands-Temperaturkoeffizienten aus und verfügen ferner über eine insbesondere bei der bestimmungsgemäßen Verwendung zur Strommessung an Batterien vorteilhafte mechanische Stabilität.

Vorzugsweise ist der Nebenwiderstand als stabförmiges Element ausgebildet. Vorzugsweise weist er zu diesem Zweck eine zylindrische Form auf. Bevorzugt verfügt der Nebenwiderstand über einen einendseitigen Endabschnitt und einen sich an den Endabschnitt unmittelbar anschließenden Mittelabschnitt. Vorzugsweise weist der Endabschnitt gegenüber dem Mittelabschnitt einen kleineren Durchmesser auf. Vorzugsweise stellt der Mittelabschnitt endabschnittseitig eine Anlagefläche bereit. Der Endabschnitt und die Anlagefläche stehen dabei mit dem Bauteil in Wirkkontakt. Besonders bevorzugt verfügt der Nebenwiderstand über jeweils einen einendseitigen Endabschnitt. Dabei ist der Mittelabschnitt den endseitigen Abschnitten unmittelbar zwischengeordnet und stellt jeweils eine endabschnittseitige Anlagefläche bereit. Gemäß einer besonders bevorzugten Ausgestaltung der Erfindung ist ein Endabschnitt des Nebenwiderstands von einem zweiten Abschnitt einer ersten Ausnehmung eines Bauteils aufgenommen. Weiter bevorzugt ist der Mittelabschnitt des Nebenwiderstands teilweise vom ersten Abschnitt der ersten Ausnehmung aufgenommen. Weiter bevorzugt steht die Kontaktfläche des zweiten Abschnitts einer ersten Ausnehmung eines Bauteils dabei in flächigem, vorzugsweise vollflächigem Kontakt mit der Anlagefläche des Mittelabschnitts des Nebenwiderstands.

Hierbei sind zwischen den Bauteilen eine Mehrzahl von stabförmigen Nebenwiderständen anordbar. Die genaue Zahl ist in Abhängigkeit der maximalen Stromstärke der Batterie festlegbar. Vorzugsweise weist die Anschlusseinrichtung drei bis sechs, besonders bevorzugt fünf Nebenwiderstände auf.

Gemäß einer alternativen Ausführungsform der Erfindung kann der Nebenwiderstand als ring- oder rohrförmiger Abschnitt ausgebildet sein. Dieser Abschnitt kann im Querschnitt beliebig, insbesondere eckig, oval, kreisförmig oder dergleichen ausgebildet sein. Der Abschnitt ist aus einem elektrisch leitenden Material, vorzugsweise aus einer der bevorzugten Legierungen gebildet. Im endmontierten Zustand steht der Abschnitt einendseitig in elektrischem Kontakt mit dem ersten Bauteil und anderenendseitig in elektrischem Kontakt mit dem zweiten Bauteil. Die Kontaktierung kann dabei mittelbar oder unmittelbar körperlicher Art sein. Vorzugsweise sind erstes Bauteil, ring- oder rohrförmiger Abschnitt und zweites Bauteil koaxial zueinander ausgerichtet und in Richtung der Rotationsachse übereinander angeordnet. Vorzugsweise ist der Abschnitt in dieser Ausgestaltung im Querschnitt kreisförmig ausgebildet. Der Radius des Abschnitts ist dabei korrespondierend mit der radialen Beabstandung der ersten Ausnehmungen auf dem ersten und dem zweiten Bauteil gewählt. In Weiterbildung der Erfindung können die ersten Ausnehmungen in radialer Richtung soweit erweitert werden, dass sie eine einzige, radial durchgehend verlaufende Nut zur Aufnahme der jeweiligen Abschnittsenden bilden. In diesem besonderen Fall ist die Verbindung zwischen erstem und zweitem Bauteil und dem Abschnitt nach Art einer Nut-Feder-Verbindung ausgestaltet. Es hat sich herausgestellt, dass diese alternative Ausgestaltung der Erfindung mechanisch besonders stabil ist.

Gemäß einem bevorzugten Merkmal der Erfindung weisen die Bauteile zweite Ausnehmungen auf. Die zweiten Ausnehmungen stellen dabei einen Volumenraum zur teilweisen Aufnahme des Verbindungselements bereit. Vorzugsweise sind die zweiten Ausnehmungen in der Aufsicht kreisförmig ausgebildet. Vorzugsweise sind die zweiten Ausnehmungen des ersten und des zweiten Bauteils hinsichtlich ihrer Positionierung miteinander korrespondierend in dem jeweiligen Bauteil angeordnet. Alternativ sind die zweiten Ausnehmungen des ersten und des zweiten Bauteils hinsichtlich ihrer Positionierung versetzt zueinander auf dem jeweiligen Bauteil angeordnet. Vorzugsweise sind die zweiten Ausnehmungen mit einem Innendurchmesser ausgebildet, der geringer ist, als der Innendurchmesser der ersten Abschnitte der ersten Ausnehmungen und der größer ist, als der Innendurchmesser der zweiten Abschnitte der ersten Ausnehmungen. Es hat sich ergeben, dass diese Größenverhältnisse der Innendurchmesser der Ausnehmungen in Verbindung mit den Aussendurchmessern der jeweiligen von den Ausnehmungen aufgenommenen Bauteile zu einer synergetischen Verbesserung der mechanischen Stabilität gegenüber nicht bestimmungsgemäßer mechanischer Belastung der Anschlusseinrichtung führt.

Gemäß einer bevorzugten Ausgestaltung der Erfindung sind die Bauteile, insbesondere in ihrer bevorzugten Ausgestaltung als Ringteile, mit kreisförmigem Umfang ausgebildet. Vorzugsweise sind die Nebenwiderstand dabei radial beabstandet voneinander angeordnet. Vorzugsweise sind die ersten Ausnehmungen zur Aufnahme der Nebenwiderstände radial beabstandet voneinander auf dem jeweiligen Bauteil angeordnet. Vorzugsweise sind die zweiten Ausnehmungen zur teilweisen Aufnahme des Verbindungselements radial beabstandet voneinander in dem jeweiligen Bauteil angeordnet. Gemäß einer besonders bevorzugten Ausgestaltung der Erfindung sind die ersten und zweiten Ausnehmungen des jeweiligen Bauteils radial von einander beabstandet und einander abwechselnd in dem jeweiligen Bauteil angeordnet.

Gemäß einem weiteren bevorzugten Merkmal der Erfindung weist das Verbindungselement Vorsprünge auf. Vorzugsweise weisen die Vorsprünge einen mit dem Innenumfang der zweiten Ausnehmungen der Bauteile korrespondieren Außenumfang auf. Vorzugsweise sind die Vorsprünge des Verbindungselements von den zweiten Ausnehmungen der Bauteile aufgenommen. Hierdurch wird in vorteilhafterweise für eine ortsfeste Positionierung des Verbindungselements Sorge getragen. Ferner dienen die Vorsprünge der für die mechanische Stabilität der Anschlusseinrichtung vorteilhaften Kraftübertragung vom Bauteil auf das Verbindungselement.

Gemäß einem bevorzugten Merkmal der Erfindung ist die Anschlusseinrichtung über Befestigungsmittel am Anschlusspol befestigbar ausgebildet. In Betracht kommen hierbei prinzipiell unlösbare und lösbare Befestigungen. Eine unlösbare Befestigung kann insbesondere durch Kleben, Löten oder Schweißen hergestellt werden. Eine solche Art der Befestigung ist mechanisch besonders stabil und kann aufgrund dessen bei mechanisch vergleichsweise stark beanspruchten Batteriesystemen von Vorteil sein. Lösbare Befestigungen umfassen insbesondere den Einsatz von Rastmitteln, Schrauben oder Verbindungsbeschlägen. Eine solche Art der Befestigung ist insbesondere mit Hinblick auf die Wartung oder den Ersatz von Anschlusseinrichtungen von Vorteil, da diese zu den vorgenannten Zwecken vom Anschlusspol der Batterie zerstörungsfrei entfernt werden können. Dies ist auch hinsichtlich einer möglichen Nachrüstung von bestehenden Batterien mit einer erfindungsgemäßen Anschlusseinrichtung von Vorteil. Besonders bevorzugt ist hierbei die mechanische Befestigung der Anschlusseinrichtung am Anschlusspol mittels einer Schraube. In diesem Fall weist die Anschlusseinrichtung ein die Bauteile und das Verbindungselement durchdringendes Durchgangsloch zur Durchführung eines Schraubenschafts auf. Die Rotationsachse des Durchgangsloches ist dabei vorzugsweise koaxial mit der Rotationsachse der Anschlusseinrichtung angeordnet. Das Durchgangsloch ist dabei vorzugsweise durchgängig mit einem solchen Innendurchmesser ausgebildet, dass der Schraubenschaft bei bestimmungsgemäßer Befestigung das Durchgangsloch unter Belassung eines radialen Spalts beabstandet von dessen Innenwandung durchdringt. Hierdurch wird ein unerwünschter elektrischer Kontakt zwischen Schraube und Anschlusseinrichtung in vorteilhafter Weise vermieden.

Das erste und das zweite Bauteil weisen ferner jeweils eine Durchgangslochöffnung auf. Die Durchgangslochöffnung des ersten Bauteils ist bei bestimmungsgemäßer Befestigung dem Schraubenende zugewandt. Die Durchgangslochöffnung des zweiten Bauteils ist bei bestimmungsgemäßer Befestigung dem Schraubenkopf zugewandt. Das zweite Bauteil ist dabei derart ausgebildet, dass der Schraubenkopf bei bestimmungsgemäßer Befestigung eine Kraft in Anschlusspolrichtung über das zweite Bauteil auf die Anschlusseinrichtung überträgt. Zu diesem Zweck kann es insbesondere vorgesehen sein, das Durchgangsloch und/oder die Durchgangslochöffnung des zweiten Bauteil mit im Vergleich zum Durchmesser der bestimmungsgemäß verwendeten Schraube mit verkleinertem Durchmesser auszubilden.

Gemäß einem bevorzugten Merkmal der Erfindung ist das erste Bauteil der Anschlusseinrichtung mit dem Anschlusspol elektrisch verbindbar ausgebildet. Die Verbindung kann dabei mittelbar oder unmittelbar ausgestaltet sein. Mittelbar bedeutet in diesem Zusammenhang die Herstellung einer elektrischen Verbindung über zusätzliche Leitungselemente, wie insbesondere Stromkabel oder dergleichen. Diese Ausgestaltung gestattet eine Anordnung der Anschlusseinrichtung entfernt vom Anschlusspol. Je nach Batterietyp und/oder örtlicher Gegebenheiten, die lediglich eine räumlich beengte Batterieanordnung zulassen, kann eine solche Ausgestaltung von Vorteil sein. Bei einer unmittelbaren elektrischen Verbindung ist hingegen ein direkter Kontakt zwischen einem elektrisch leitenden Anschlussbereich des ersten Bauteils und einem elektrisch leitenden Anschlussbereich des Anschlusspols hergestellt. Vorzugsweise ist der Anschlussbereich des ersten Bauteils dabei in Entsprechung eines Anschlussbereiches eines aus dem Stand der Technik bekannten ansonsten unmittelbar mit dem Anschlusspol elektrisch verbundenen Stromabnehmers ausgebildet. Eine solche Ausgestaltung ist insbesondere hinsichtlich einer möglichen Nachrüstung von bestehenden Batterien mit einer erfindungsgemäßen Anschlusseinrichtung von Vorteil, da bereits bestehende Anschlussbereiche der nachzurüstenden Anschlusspole in einfacher Weise genutzt werden können. Vorzugsweise weist der Anschlussbereich des ersten Bauteils eine mit dem Anschlussbereich des Anschlusspols korrespondierende Form auf. Im Falle, dass die Anschlusseinrichtung über ein Durchgangsloch verfügt, ist es vorgesehen, dass der Anschlussbereich des ersten Bauteils von der Innenwandung des vom ersten Bauteil bereitgestellten Teils des Durchgangsloches gebildet ist. Alternativ oder in Kombination mit dieser Ausgestaltung kann es ferner vorgesehen sein, dass der Anschlussbereich des ersten Bauteils weitere Bereiche des ersten Bauteils umfasst. Insbesondere kann es vorgesehen sein, dass der Anschlussbereich einen sich ringförmig an die Durchgangslochöffnung anschließenden und diese in sich aufnehmenden Teil der anschlusspolseitigen Oberfläche des ersten Bauteils umfasst.

Gemäß einem bevorzugten Merkmal der Erfindung ist das zweite Bauteil der Anschlusseinrichtung mit einem aus dem Stand der Technik bekannten Stromabnehmer elektrisch verbindbar ausgebildet. Die Verbindung kann dabei wiederum mittelbar oder unmittelbar ausgestaltet sein. Im Falle einer unmittelbaren elektrischen Verbindung zwischen zweitem Bauteil und Stromabnehmer stellt das zweite Bauteil einen geeigneten Anschlussbereich bereit. Dieser ist vorzugsweise in Entsprechung des Anschlussbereiches eines Anschlusspols einer aus dem Stand der Technik bekannten Batterie ausgebildet. Vorzugsweise weist der Anschlussbereich des ersten Bauteils dabei eine mit einem Anschlussbereich des Stromabnehmers korrespondierende Form auf. Im Falle, dass die Anschlusseinrichtung über ein Durchgangsloch verfügt, ist es dabei insbesondere vorgesehen, dass das zweite Bauteil einen die Durchgangslochöffnung, vorzugsweise vollständig, radial einfassenden Rand aufweist. Der Rand ist vorzugsweise gegenüber der äußeren Oberfläche des zweiten Bauteils erhöht ausgebildet. Der Rand dient damit der Kontaktierung des Stromabnehmers, wie insbesondere einem aus dem Stand der Technik bekannten Verbinder, zur Herstellung einer elektrischen Verbindung zwischen Rand und Stromabnehmer.

Gemäß einem bevorzugten Merkmal der Erfindung sind die Bauteile und das Verbindungselement außenseitig mit einer elektrischen Isolation versehen. Diese kann insbesondere in Form einer elektrisch isolierenden Ummantelung oder Beschichtung ausgebildet sein. Bevorzugt ist die Beschichtung oder die Ummantelung zweistückig mit dem Verbindungselement ausgebildet. Alternativ kann die Beschichtung einstückig mit dem Verbindungselement ausgebildet sein. In diesem Fall wird zur Herstellung des Nebenwiderstands eine Anordnung aus den beiden Bauteilen und dem wenigstens einen Nebenwiderstand in einer Gussform platziert. Alsdann wird eine Kunststoffgussmasse in die Gussform eingebracht und bildet nach dem Aushärten Verbindungselement und Beschichtung. Diese Verfahrensweise ist selbstverständlich unter Verwendung einer geeigneten Gussform auch für die Herstellung und Anordnung des Verbindungselements oder der Beschichtung alleine geeignet. Durch die Beschichtung kann die Bildung unerwünschter elektrischer Bypässe ausgehend von den Bauteilen in vorteilhafter Weise verhindert werden.

Gemäß einem weiteren bevorzugten Merkmal der Erfindung ist der Anschlussbereich des ersten Bauteils isolationsfrei, vorzugsweise beschichtungsfrei, ausgebildet. Hierdurch wird in Kombination mit der übrigen, vollständigen äußeren elektrisch isolierenden Beschichtung des ersten Bauteils die Herstellung einer elektrischen Verbindung zwischen dem Anschlussbereich des ersten Bauteils und einem Anschlusspol in vorteilhafter Weise ermöglicht, ohne dass es zur Ausbildung unerwünschter elektrischer Bypässe an sonstigen Teilen des ersten Bauteils kommt.

Gemäß einem weiteren bevorzugten Merkmal der Erfindung ist der Anschlussbereich des zweiten Bauteils isolationsfrei, vorzugsweise beschichtungsfrei, ausgebildet. Hierdurch wird in Kombination mit der übrigen, vollständigen äußeren elektrisch isolierenden Beschichtung des zweiten Bauteils die Herstellung einer elektrischen Verbindung zwischen dem Anschlussbereich des zweiten Bauteils und einem Stromabnehmer in vorteilhafter Weise ermöglicht, ohne dass es zur Ausbildung unerwünschter elektrischer Bypässe an sonstigen Teilen des zweiten Bauteils kommt.

Zur Lösung der der Erfindung zugrunde liegenden Aufgabe wird ferner eine Batterieanordnung vorgeschlagen, aufweisend eine Batterie, eine erfindungsgemäße Anschlusseinrichtung und einen Stromabnehmer, wobei die Batterie Anschlusspole bereitstellt, wobei die Anschlusseinrichtung zwischen einem der Anschlusspole und dem Stromabnehmer angeordnet ist und diese elektrisch miteinander verbindet.

Durch die erfindungsgemäße Anordnung ist die Anschlusseinrichtung gegenüber einer für die aus dem Stand der Technik bekannte Batterieanordnung nicht zu bewältigende Relativbewegung zwischen mehreren Batterien vollständig spannungsfrei gestellt. In Kombination mit der erfindungsgemäßen Anschlusseinrichtung ist die Batterieanordnung damit weitgehend unempfindlich gegenüber unsachgemäßer Krafteinwirkung. Hierdurch kann nun erstmals eine Messung der Stromabnahme an einer Batterie über die gesamte Lebensdauer der Batterie im alltäglichen Gebrauch realisiert werden.

Gemäß einer bevorzugten Ausgestaltung der Erfindung sind die Anschlusseinrichtung und der Stromabnehmer mittels eines Befestigungsmittels am Anschlusspol befestigt. Als Befestigungsmittel können insbesondere Rastmittel, Schrauben, Verbindungsbeschläge oder dergleichen eingesetzt werden. Bevorzugt ist die Befestigung von Stromabnehmer und Anschlusseinrichtung mittels einer Schraube. Hierzu weisen Anschlusseinrichtung und Stromabnehmer jeweils ein Durchgangsloch auf, durch welches die Schraube durchsteckbar ist. Der Anschlusspol stellt zur ordnungsgemäßen Befestigung vorzugsweise ein Schraubloch mit Schraubgewinde bereit. Vorzugsweise sind die Durchgangslöcher von Stromabnehmer und Anschlusseinrichtung sowie das Schraubloch des Anschlusspols unmittelbar übereinander koaxial miteinander angeordnet und sind durch die Schraube in direktem Kontakt gehalten. Hierdurch sind Stromabnehmer, Anschlusseinrichtung und Anschlusspol mechanisch miteinander verbunden, wodurch im Falle einer bestimmungsfremden Krafteinwirkung auf die Batterie verhindert ist, dass es zu einer Relativbewegung zwischen einzelnen Komponenten kommt. Eine hieraus gegebenenfalls resultierende Beschädigung von Anschlusseinrichtung und Anschlusspol kann dadurch vermieden werden, wodurch im Ergebnis einerseits der Wartungsaufwand verringert und die Lebenszeit sowohl von Anschlusseinrichtung, als auch von Batterie in vorteilhafter Weise verlängert wird.

Erfindungsgemäß sind Anschlusspol, Anschlusseinrichtung und Stromabnehmer elektrisch miteinander verbunden. Zu diesem Zweck stellen Anschlusspol und Stromabnehmer jeweils einen anschlusseinrichtungsseitigen Anschlussbereich bereit. Die Anschlusseinrichtung stellt ihrerseits jeweils einen stromabnehmerseitigen Anschlussbereich und einen anschlusspolseitigen Anschlussbereich zur Verfügung. Die einander anschlussmäßig zugeordneten Anschlussbereiche der Komponenten sind dabei miteinander korrespondierend ausgeformt. Um reproduzierbare Messergebnisse zu erhalten, ist es hierbei erforderlich, dass der von der Batterie bereitgestellte Strom ausschließlich durch den Nebenwiderstad fließt. Es ist daher vorgesehen, dass ein elektrisch leitend ausgebildeter anschlusseinrichtungsseitiger Anschlussbereich des Anschlusspols ausschließlich mit dem Anschlussbereich des ersten Bauteil der Anschlusseinrichtung in unmittelbarem elektrischem Kontakt steht. In Vorteilhafterweise kann hierdurch die Bildung von den Nebenwiderstand umgehenden Strombypässen verhindert werden.

Gemäß einem bevorzugten Merkmal der Erfindung weist die Schraube einen elektrisch isolierten Schraubenkopf und einen sich unmittelbar an den Schraubenkopf anschließenden elektrisch isolierten Schaft auf, wobei die Isolierung des Schafts bei ordnungsgemäßer Befestigung wenigstens im Überlappungsbereich mit den Durchgangsöffnungen von Stromabnehmer und Anschlusseinrichtung ausgebildet ist. Vorzugsweise reicht die Isolierung bei bestimmungsgemäßer Befestigung über den Überlappungsbereich hinaus. Hierdurch kann die Ausbildung unerwünschter Strombypässe über die Schraube in vorteilhafter Weise verhindert werden.

Die erfindungsgemäßen und die bevorzugten Merkmale erbringen für sich genommen und in Kombination miteinander eine Reihe von synergetischen Vorteilen gegenüber dem Stand der Technik. So ist mit der Erfindung erstmals eine Anschlusseinrichtung und eine Batterieanordnung aufweisend eine Anschlusseinrichtung beschrieben, die unempfindlich gegenüber unsachgemäßer mechanischer Krafteinwirkung sind. Es ist daher durch die Erfindung erstmals möglich, die Stromabnahme an einer Batterie über die gesamte Lebensdauer der Batterie im alltäglichen Gebrauch reproduzierbar zu überwachen.

Die Erfindung wird nachfolgend anhand eines für die Gesamtoffenbarung in keiner Weise beschränkend zu verstehenden Ausführungsbeispiels näher erläutert. Dabei zeigt
- Fig. 1: eine Batterieanordnung gemäß dem Stand der Technik in Explosivdarstellung;
- Fig. 2: eine Anschlusseinrichtung gemäß der Erfindung in schematischer Darstellung;
- Fig. 3: ein erstes Bauteil mit einem Nebenwiderstand gemäß der Erfindung in schematischer Darstellung;
- Fig. 4: einen Teil einer erfindungsgemäßen Anschlusseinrichtung ohne zweites Bauteil in schematischer Darstellung;
- Fig. 5: eine außenseitig mit einem elektrisch isolierenden Material beschichtete Anschlusseinrichtung gemäß der Erfindung in schematischer Darstellung;
- Fig. 6: eine Schraube gemäß der Erfindung in schematischer Darstellung;
- Fig. 7: eine erfindungsgemäße Anschlusseinrichtung mit Schraube in schematischer Darstellung;
- Fig. 8: eine Batterieanordnung gemäß der Erfindung in schematischer Explosivdarstellung.

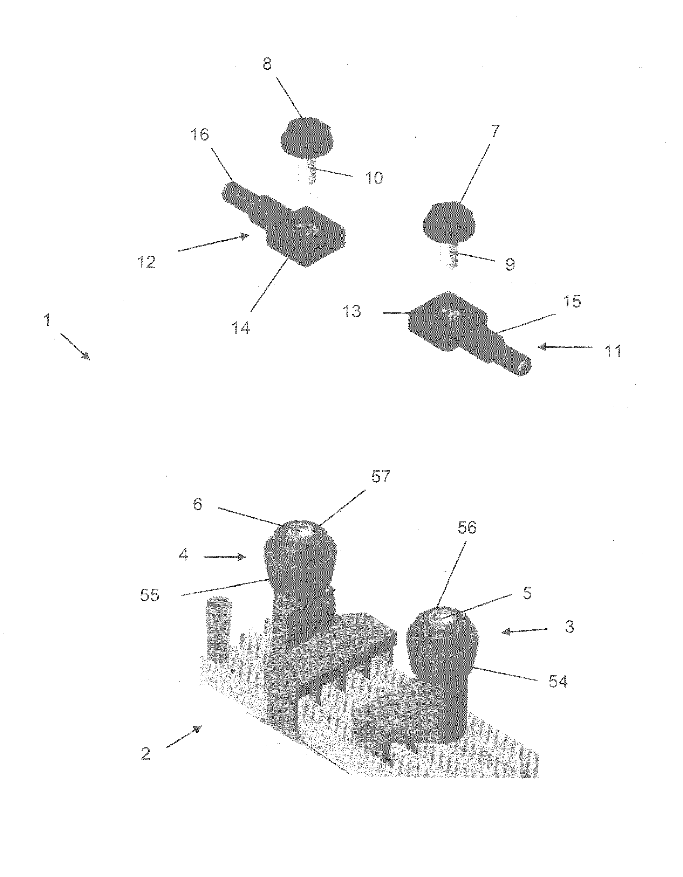

Fig. 1 zeigt eine aus dem Stand der Technik bekannte Batterieanordnung 1. Eine lediglich ausschnittsweise gezeigte Batterie 2 stellt Anschlusspole 3, 4 bereit.

Die Anschlusspole 3, 4 sind mit einer Mehrzahl von Batteriezellen elektrisch verbunden. Sie weisen eine außenseitige elektrische Isolierung 54, 55 auf. Der Anschlusspols 3, 4 stellt des Weiteren einen bronzenen Rand 56, 57 bereit, welcher elektrisch leitend und isolationsfrei ausgebildet ist. Der Rand 56, 57 begrenzt dabei ein vom Anschlusspol 3, 4 bereitgestelltes bronzenes Schraubloch 5, 6 aufweisend ein Schraubgewinde. Das Schraubloch 5, 6 dienen der Aufnahme der Schrauben 7, 8. Die Schrauben 7, 8 weisen einen elektrisch isolierten Schraubenkopf auf. Der Schaft 9, 10 der Schraube 7, 8 ist elektrisch leitend ausgebildet und ansonsten elektrisch nicht isoliert.

Die Schraube 7, 8 dient der mechanischen Befestigung und elektrischen Verbindung des Anschlusspols 5, 6 mit dem Verbinder 11, 12. Der Verbinder 11, 12 dient der elektrischen Koppelung zweier oder einer Mehrzahl von Batterien 2. Die Verbinder 11, 12 weisen hierbei ein Durchgangsloch 13, 14 auf. Der Verbinder 11, 12 weist eine äußere elektrische Isolierung 15, 16 auf. Bei bestimmungsgemäßer Anordnung ist das Durchgangsloch 13, 14 über den Rand 56, 57 des Anschlusspols 3, 4 geführt, wobei die Innenwandung des Loches 13, 14 mit der Außenwandung des Rands 56, 57 in elektrischem Kontakt steht. Auf diesem Wege fließt der Strom sowohl vom Schraubloch 5, 6 des Anschlusspols 3, 4 in die Schraube 7, 8 und anschließend in den Verbinder 11, 12 als auch unmittelbar vom Rand 56, 57 des Anschlusspols 3, 4 in den Verbinder 11, 12.

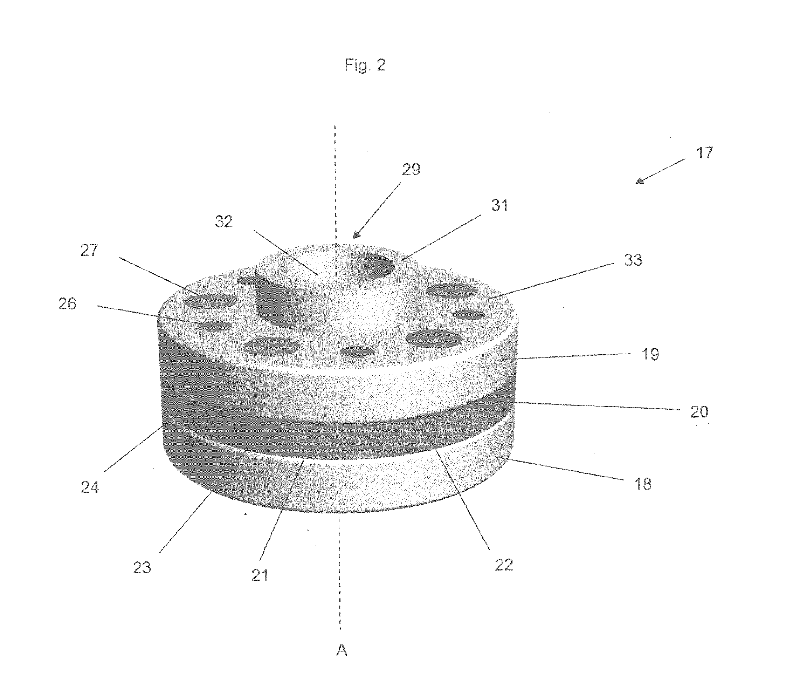

Fig. 2 zeigt eine erfindungsgemäße Anschlusseinrichtung 17. Die Anschlusseinrichtung 17 weist ein erstes Bauteil 18 in Form eines flächigen Ringteils und ein zweites Bauteil 19 in Form eines flächigen Ringteils auf. Zwischen dem ersten Bauteil 18 und dem zweiten Bauteil 19 ist ein Verbindungselement 20 angeordnet. Die Bauteile 18, 19 sind vorliegend aus Kupfer gebildet. Das Verbindungselement 20 ist vorliegend aus einem thermoplastischen Elastomer gebildet.

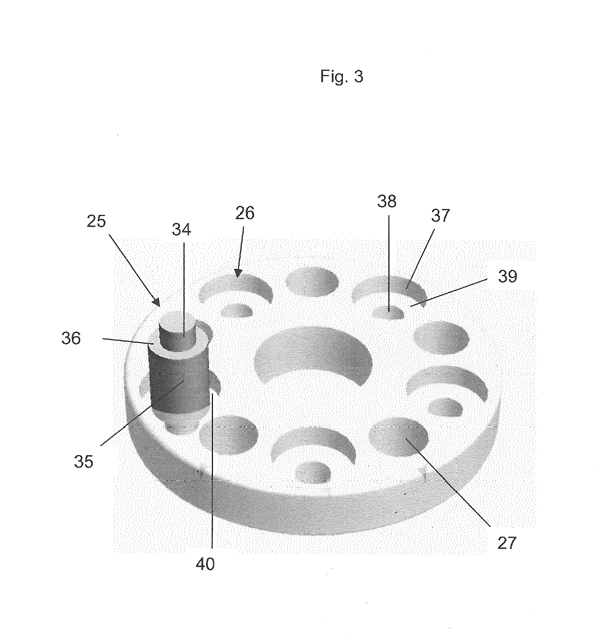

Die verbindungselementseitigen Oberflächen 21, 22 der Bauteile 18, 19 sind in Richtung ihrer Flächenerstreckung im Wesentlichen parallel zueinander ausgerichtet. Die Bauteile 18, 19 und das Verbindungselement 20 weisen in der Aufsicht eine kreisförmige Form auf. Der aufsichtige Umfang des ersten Bauteils 18, des zweiten Bauteils 19 und des Verbindungselements 20 sind im Wesentlichen identisch ausgebildet. Vorliegend steht die verbindungselementseitige Oberfläche 21 des ersten Bauteils 18 in unmittelbarem vollflächigem Kontakt zu der ihr zugewandten Oberfläche 23 des Verbindungselements 20. Ferner steht die verbindungselementseitige Oberfläche 22 des zweiten Bauteils 19 in unmittelbarem vollflächigem Kontakt zu der ihr zugewandten Oberfläche 24 des Verbindungselements 20. Hierdurch wird eine mechanische Stabilisierung gegenüber unsachgemäßer Krafteinwirkung der Bauteile 18, 19 und der mit ihnen verbundenen, in Fig. 3 näher dargestellten, Nebenwiderständen 25 im Besonderen und der Anschlusseinrichtung 17 im Allgemeinen erreicht.

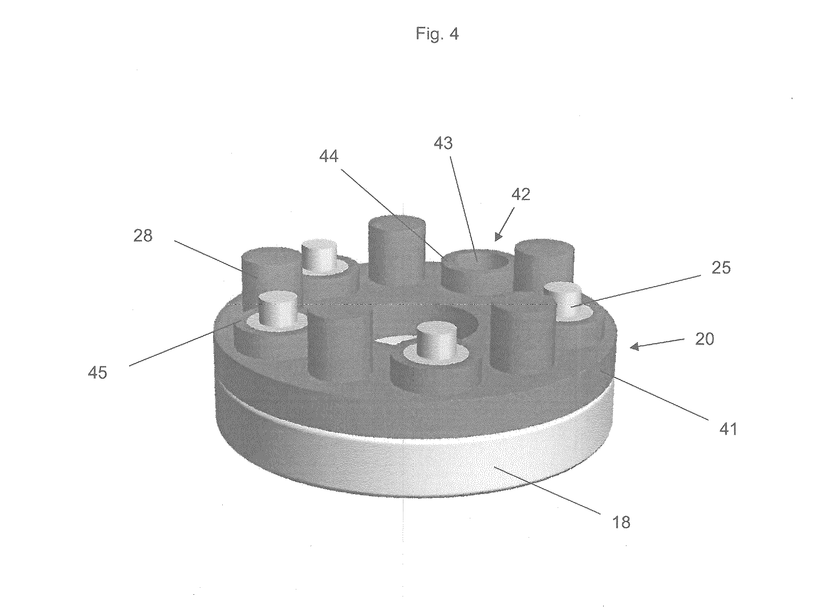

Am Beispiel des zweiten Bauteils 19 ist ersichtlich, dass beide Bauteile 18, 19 jeweils über in Fig. 3 im Detail dargestellte fünf erste Ausnehmungen 26 verfügen. Die ersten Ausnehmungen 26 sind radial beabstandet voneinander in den Bauteilen 18, 19 angeordnet. Ferner sind die ersten Ausnehmungen 26 vorliegend äquidistant zueinander beabstandet. Sie dienen der teilweisen Aufnahme von insgesamt fünf Nebenwiderständen 25. Die Bauteile 18, 19 stellen ferner jeweils fünf zweite Ausnehmungen 27 bereit. Die zweiten Ausnehmungen 27 sind radial beabstandet voneinander in den Bauteilen 18, 19 angeordnet. Sie dienen der vollständigen Aufnahme von insgesamt fünf in Fig. 4 näher dargestellten Vorsprüngen 28 des Verbindungselements 20.

Ferner sind die zweiten Ausnehmungen 27 vorliegend äquidistant zueinander beabstandet. Die ersten Ausnehmungen 26 und die zweiten Ausnehmungen 27 sind dabei einander abwechselnd in den Bauteilen 18, 19 angeordnet. Ferner sind die Bauteile 18, 19 derart angeordnet, dass die Positionierung der ersten Ausnehmungen 26 des ersten Bauteils 18 mit den ersten Ausnehmungen 26 des zweiten Bauteils korrespondiert. Darüber hinaus sind die Bauteile 18, 19 ferner derart angeordnet, dass die Positionierung der zweiten Ausnehmungen 27 des ersten Bauteils 18 mit den zweiten Ausnehmungen 27 des zweiten Bauteils korrespondiert.

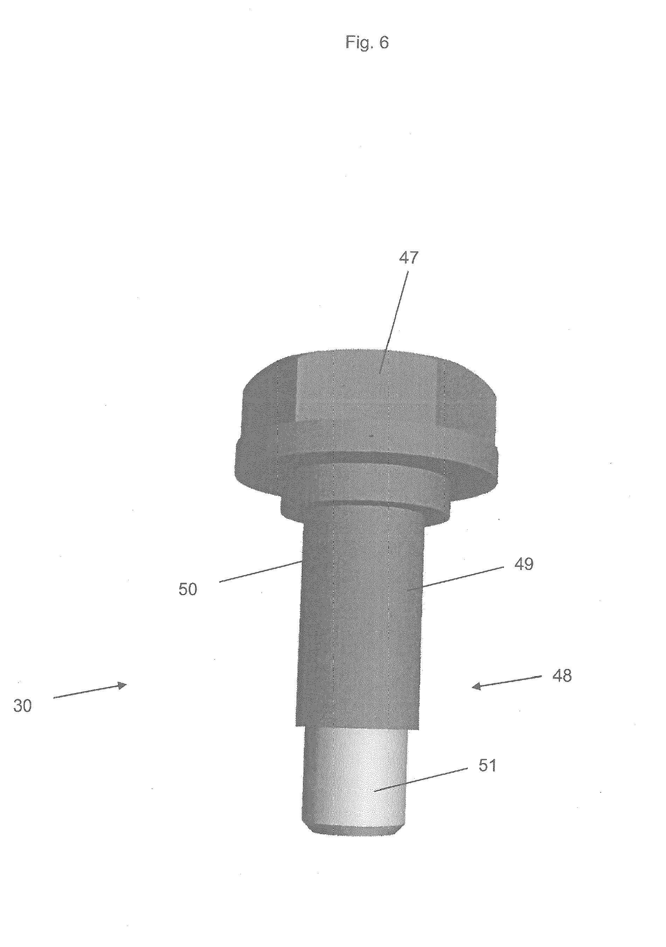

Die Anschlusseinrichtung 17 weist vorliegend ein gewindeloses Durchgangsloch 29 zur Aufnahme und Führung einer erfindungsgemäßen in Fig. 6 näher dargestellten Schraube 30 auf. Dieses durchdringt die gesamte Anschlusseinrichtung 17 in Tiefenrichtung. Vorliegend stellen daher das erste Bauteil 18, das zweite Bauteil 19 und das Verbindungselement 20 jeweils einen Teil des Durchgangsloches 29 bereit. Das Durchgangsloch 29 ist vorliegend in der Aufsicht kreisförmig ausgebildet. Ferner ist das Durchgangsloch 29 koaxial zu der Rotationsachse A der Anschlusseinrichtung 17 in der Anschlusseinrichtung 17 ausgerichtet.

Das zweite Bauteil 19 weist einen Rand 31 auf. Der Rand 31 fasst die Durchgangslochöffnung 32 des Durchgangslochs 29 vollständig ein. Er dient dabei der elektrischen Verbindung zwischen Verbinder 11, 12 und der Anschlusseinrichtung 17. Er erstreckt sich im rechten Winkel in Richtung von der äußeren Oberfläche 33 des zweiten Bauteils 19 weg.

Der Innendurchmesser des Durchgangsloches 29 der Anschlusseinrichtung 17 entspricht dabei dem Innendurchmesser des Durchgangsloches 13, 14 des Verbinders 11, 12. Darüber hinaus entspricht der Außendurchmesser des Rands 31 der Anschlusseinrichtung 17 dem Außendurchmesser des Rands 56, 57 des Anschlusspols 3, 4. Es wird hierdurch sichergestellt, dass herkömmliche Anschlusspole 3, 4 und herkömmliche Verbinder 11, 12 in Verbindung mit der erfindungsgemäßen Anschlusseinrichtung 17 verwendet werden können. Hierdurch wird es möglich, bestehende Batterien in einfacher Weise mit einer erfindungsgemäßen Anschlusseinrichtung 17 nachzurüsten.

Fig. 3 zeigt ein erstes Bauteil 18 der Anschlusseinrichtung 17 und ein Nebenwiderstand 25. Das erste Bauteil 18 weist erste Ausnehmungen 26 und zweite Ausnehmungen 27 gemäß den in Fig. 2 gezeigten Merkmalen auf.

Der Nebenwiderstand 25 ist vorliegend zylinderförmig ausgebildet. Er besteht aus einer Legierung mit der Zusammensetzung Cu₈₄Mn₁₂Ni₄. Er verfügt dabei über zwei beidendseitige Endabschnitte 34 und einen den Endabschnitten unmittelbar zwischengeordneten Mittelabschnitt 35. Die Endabschnitte 34 weisen vorliegend gegenüber dem Mittelabschnitt 35 einen reduzierten Durchmesser auf. Der Mittelabschnitt 35 stellt dabei endabschnittseitig jeweils eine Anlagefläche 36 bereit.

Die ersten Ausnehmungen 26 stellen einen Volumenraum zur teilweisen Aufnahme der Nebenwiderstände 25 zur Herstellung jeweils einer elektrischen leitenden Verbindung zwischen dem jeweiligen Nebenwiderstand 25 und den Bauteilen 18, 19 bereit. Die ersten Ausnehmungen 26 weisen vorliegend einen ersten Abschnitt 37 und einen zweiten Abschnitt 38 auf. Der erste Abschnitt 37 weist dabei einen größeren Innendurchmesser auf als der zweite Abschnitt 38. Die zwei Abschnitte 37, 38 sind in Tiefenrichtung des Bauteils koaxial übereinander angeordnet sind. Der zweite Abschnitt 38 stellt erstabschnittseitig durch seinen im Vergleich zum ersten Abschnitt 37 geringeren Innendurchmesser eine Kontaktfläche 39 zur Kontaktierung des Nebenwiderstands 25 bereit.

Jeweils ein Endabschnitt 34 eines Nebenwiderstands 25 ist bei der erfindungsgemäßen Anordnung von einem vom zweiten Abschnitt 38 bereitgestellten Volumenraum vollständig aufgenommen. Hierbei steht die nebenwiderstandseitige Innenwand des zweiten Abschnitts 38 mit der zweitabschnittsseitigen Außenwand des Endabschnitts 34 in flächigem unmittelbaren elektrischem Kontakt.

Ferner stehen die Anlagefläche 36 des Nebenwiderstands und die Kontaktfläche 39 des zweiten Abschnitts 39 in flächigem unmittelbarem elektrischen Kontakt. Es ist darüber hinaus ersichtlich, dass ein Teil des Mittelabschnitts 35 des Nebenwiderstands 25 unter Belassung eines Spalts 40 vom ersten Abschnitt 37 der ersten Ausnehmung 26 aufgenommen ist.

Fig. 4 zeigt einen Teil der Anschlusseinrichtung 17. Abweichend von Fig. 2 ist das zweite Bauteil 19 entfernt worden. Deutlich erkennbar sind nun die Vorsprünge 28 des Verbindungselements 20. Diese sind beidseitig und einander gegenüberliegend am Körper 41 des Verbindungselements 20 angeordnet. Die Vorsprünge 28 sind vorliegend zylindrisch ausgebildet. Sie sind dabei rechtwinklig zum Körper 41 des Verbindungselements 20 ausgerichtet. Bei bestimmungsgemäßer Anordnung sind die beidseitig angeordneten Vorsprünge 28 von den zweiten Ausnehmungen 27 des ersten Bauteils 18 einerseits und den zweiten Ausnehmungen 27 des zweiten Bauteils 19 andererseits vollständig aufgenommen.

Das Verbindungselement weist ferner dritte Ausnehmungen 42 auf. Diese durchdringen das Verbindungselement 20 vollständig und stellen jeweils einen zylindrischen Volumenraum 43 zur vollständigen Aufnahme des Mittelabschnitts 35 der Nebenwiderstände 25 bereit. Ein Volumenraum 43 wird vorliegend jeweils vom Körper 41 und von einem beidseits am Körper 41 angeordneten Rand 44 begrenzt. Die Ränder 44 des Verbindungselements 20 stellen bauteilseitig eine Randfläche 45 bereit. Die Randfläche 45 schließt kontaktflächenseitig mit der Anlagefläche 36 des korrespondierenden Mittelabschnitts 35 des aufgenommenen Nebenwiderstands 25 bündig ab. Der Rand 44 ist vorliegend im Spalt 40 des ersten Abschnitts 37 der ersten Ausnehmung 26 angeordnet. Er ist insofern im Querschnitt zwischen der erstabschnittsseitigen Außenwand des Endabschnitts 34 und der endabschnittsseitigen Innenwand des ersten Abschnitts 37 angeordnet. Der Rand 44 schließt ferner vorliegend mit der erstabschnittsseitigen Außenwand des Endabschnitts 34 und der endabschnittsseitigen Innenwand des ersten Abschnitts 37 bündig ab. Durch die erfindungsgemäße Ausgestaltung ist eine mechanisch besonders stabile Verbindung zwischen Nebenwiderstand 25 und Bauteilen 18, 19 bereitgestellt. Sie ist durch die erfindungsgemäße Zwischenordnung des Verbindungselements 20 gegenüber unsachgemäße Krafteinwirkungen aus allen drei Raumrichtungen geschützt.

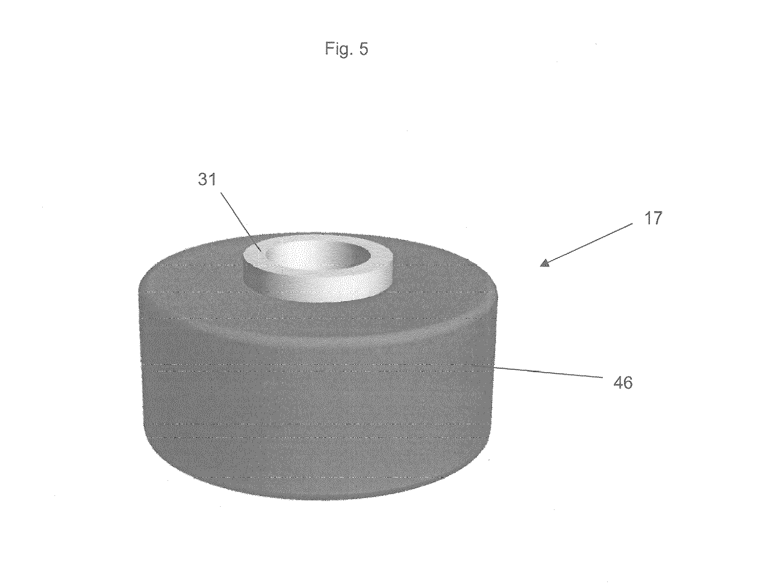

Fig. 5 zeigt eine Anschlusseinrichtung 17. Die Anschlusseinrichtung 17 weist eine außenseitige Beschichtung 46 auf. Die Beschichtung 46 ist aus einem elektrisch isolierenden Material, vorliegend Kunststoff, gebildet. Die Anschlusseinrichtung 17 ist mit Ausnahme des Rands 31 vollständig mit der Beschichtung 46 beschichtet. Der Rand 31 ist beschichtungsfrei ausgebildet. Hierdurch wird einerseits eine elektrische Verbindung zwischen Anschlusseinrichtung 17 und Verbinder 11, 12 sichergestellt und andererseits die Bildung unerwünschter elektrischer Bypässe ausgehend von der Anschlusseinrichtung 17 vollständig unterbunden.

Fig. 6 zeigt eine Schraube 30 gemäß der Erfindung. Die Schraube 30 weist einen Schraubenkopf 47 sowie einen Schaft 48 auf. Der Schraubenkopf 47 und ein schraubenkopfseitiger Bereich 49 des Schafts 48 sind durchgehend mit einer elektrisch isolierenden Beschichtung 50 versehen. Ein endseitiger Bereich 51 des Schafts 48 ist hingegen isolierungsfrei ausgebildet. Bestimmungsgemäß steht der isolierungsfreie Bereich 51 mit dem Schraubgewinde 5, 6 des Anschlusspols 3, 4 in Kontakt. Anschlusseinrichtung 17 und Verbinder 11, 12 stehen im bestimmungsgemäßen Verwendungsfall hingegen lediglich mit dem elektrisch isolierten Bereich 49 des Schafts 48 in Kontakt. Hierdurch wird einerseits eine mechanische belastbare Verbindung zwischen Anschlusspol 5, 6 einerseits und Anschlusseinrichtung 17 und Verbinder 11, 12 andererseits sichergestellt und zusätzlich die Bildung unerwünschter elektrischer Bypässe unter elektrischer Umgehung der Nebenwiderstände 25 über die Schraube 30 verhindert.

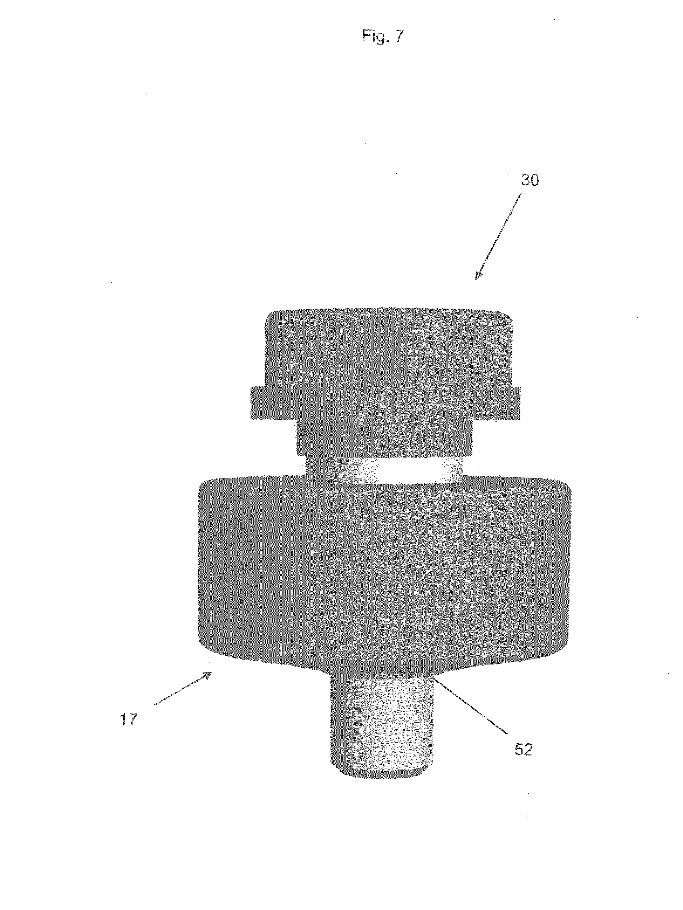

Fig. 7 zeigt eine in der Anschlusseinrichtung 17 geführte Schraube 30. Die Anschlusseinrichtung 17 ist gemäß Fig. 5 mit einer elektrisch isolierenden Beschichtung 46 beschichtet. Es ist ferner ersichtlich, dass der elektrisch isolierte Bereich 49 des Schafts 48 aus der Durchgangslochöffnung 52 heraus und damit über den Überlappungsbereich mit der Anschlusseinrichtung hinaus ragt. Hierdurch wird die Bildung unerwünschter elektrischer Bypässe zwischen Anschlusspol 3, 4 und erstem Bauteil 18 in besonders vorteilhafterweise verhindert.

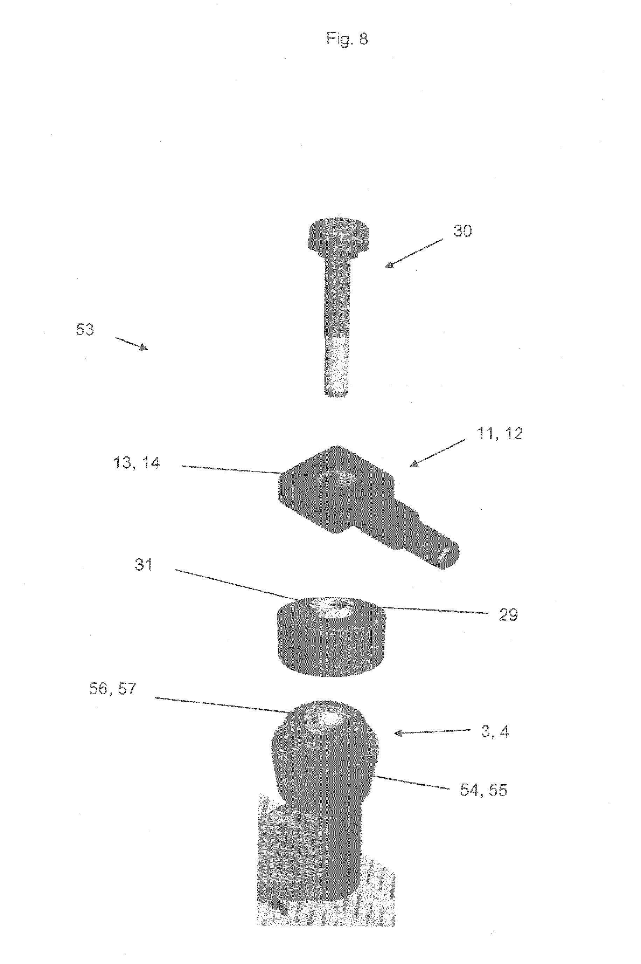

Fig. 8 zeigt eine Batterieanordnung 53 gemäß der Erfindung. Diese weist einen aus dem Stand der Technik bekannten Anschlusspol 3, 4 und einen aus dem Stand der Technik bekannten Verbinder 11, 12 auf. Ferner weist die Batterieanordnung 53 eine erfindungsgemäße Anschlusseinrichtung 17 und eine erfindungsgemäße Schraube 30 auf.

Der Verbinder 11, 12 ist über den isolierungsfrei ausgebildeten Rand 31 des zweiten Bauteils 19 der Anschlusseinrichtung 17 geführt. Das Durchgangsloch 13, 14 des Verbinders 11, 12 nimmt den Rand 31 dabei kontaktierend auf. Die Innenwandung des Durchgangsloches 13, 14 steht dabei in unmittelbarem elektrischem Kontakt mit der Außenwandung des Rands 31.

Die Anschlusseinrichtung 17 ist über den isolierungsfrei ausgebildeten Rand 56, 57 des Anschlusspols 3, 4 geführt. Das Durchgangsloch 29 der Anschlusseinrichtung 17 nimmt mit der Durchgangslochöffnung 52 des ersten Bauteils 18 den Rand 56, 57 kontaktierend auf. Die Innenwandung des Durchgangsloches 29 steht dabei in unmittelbarem elektrischem Kontakt mit der Außenwandung des Rands 56, 57.

Damit ergibt sich insgesamt ein elektrischer Leitungsweg, bei dem der Strom vom Anschlusspol 3, 4 unmittelbar und ausschließlich durch das anschlusspolseitige erste Bauteil 18, von dem ersten Bauteil 18 durch die Nebenwiderstände 25, von den Nebenwiderständen 25 durch das verbinderseitige zweite Bauteil 19 und von dem zweiten Bauteil 19 in den Verbinder 11, 12 fließt und der ansonsten frei von unerwünschten elektrischen Bypässen ist. Hierdurch wird in vorteilhafter Weise gewährleistet, dass der von der Batterie abgegebene Strom bypassfrei durch den Nebenwiderstand fließt, um die Ermittlung reproduzierbarer Messergebnisse zu ermöglichen.

Zur mechanischen Befestigung ist das Durchgangsloch 13, 14 des Verbinders 11, 12, das Durchgangsloch 29 der Anschlusseinrichtung 17 und das Schraubloch 5, 6 des Anschlusspols 3, 4 koaxial übereinander angeordnet. Die Schraube 30 ist durch das Durchgangsloch 13, 14 und das Durchgangsloch 29 durchgesteckt. Der isolierungsfrei ausgebildete Bereich 51 des Schafts 48 ist mit dem Gewinde des Schraubloch 5, 6 des Anschlusspols 3, 4 verschraubt. Hierdurch wird vom Schraubenkopf 47 ein Anpressdruck auf Verbinder 11, 12 und Anschlusseinrichtung 17 in Richtung des Anschlusspols 3, 4 ausgeübt. Eine solche Verbindung hat sich hinsichtlich einer unsachgemäßen mechanischen Einwirkung auf die Batterieanordnung als besonders stabil erwiesen.

Anschlusseinrichtung und Batterieanordnung gemäß dem Ausführungsbeispiel sind in vorteilhafter Weise unempfindlich gegenüber unsachgemäßer mechanischer Krafteinwirkung. Es ist daher durch die Erfindung erstmals möglich, die Stromabnahme an einer Batterie über die gesamte Lebensdauer der Batterie im alltäglichen Gebrauch reproduzierbar zu überwachen.

### Bezugszeichenliste

- 1: Batterieanordnung nach dem Stand der Technik
- 2: Batterie
- 3: Anschlusspol
- 4: Anschlusspol
- 5: Schraubloch
- 6: Schraubloch
- 7: Schraube
- 8: Schraube
- 9: Schaft
- 10: Schaft
- 11: Verbinder
- 12: Verbinder
- 13: Durchgangsloch
- 14: Durchgangsloch
- 15: elektrische Isolierung
- 16: elektrische Isolierung
- 17: Anschlusseinrichtung
- 18: erstes Bauteil
- 19: zweites Bauteil
- 20: Verbindungselement
- 21: verbindungselementseitige Oberfläche des ersten Bauteils
- 22: verbindungselementseitige Oberfläche des zweiten Bauteils
- 23: bauteilseitige Oberfläche des Verbindungselements
- 24: bauteilseitige Oberfläche des Verbindungselements
- 25: Nebenwiderstand
- 26: erste Ausnehmungen
- 27: zweite Ausnehmungen
- 28: Vorsprünge
- 29: Durchgangsloch
- 30: Schraube
- 31: Rand
- 32: Durchgangslochöffnung
- 33: äußere Oberfläche des zweiten Bauteils
- 34: Endabschnitt
- 35: Mittelabschnitt
- 36: Anlagefläche
- 37: erster Abschnitt
- 38: zweiter Abschnitt
- 39: Kontaktfläche
- 40: Spalt
- 41: Körper
- 42: dritte Ausnehmung
- 43: Volumenraum
- 44: Rand
- 45: Randfläche
- 46: elektrisch isolierende Beschichtung
- 47: Schraubenkopf
- 48: Schaft
- 49: elektrisch isolierter Bereich
- 50: Beschichtung
- 51: isolierungsfreier Bereich
- 52: Durchgangslochöffnung
- 53: Batterieanordnung nach der Erfindung
- 54: elektrische Isolierung
- 55: elektrische Isolierung
- 56: Rand
- 57: Rand
- A: Rotationsachse

## Patentansprüche

1. Anschlusseinrichtung für eine Batterie zur Zwischenschaltung zwischen einen Batterieanschluss und einen an der Batterie angeschlossenen Verbraucher, aufweisend ein elektrisch leitend ausgebildetes erstes Bauteil, ein elektrisch leitend ausgebildetes zweites Bauteil, wenigstens ein elektrisch leitend ausgebildeter Nebenwiderstand und ein elektrisch isolierend ausgebildetes Verbindungselement, wobei die Bauteile unter Zwischenordnung des Verbindungselements voneinander beabstandet angeordnet sind, wobei das Verbindungselement zur mechanischen Verbindung der Bauteile mit dem ersten und dem zweiten Bauteil in Kontakt steht und wobei der Nebenwiderstand zur elektrischen Verbindung der Bauteile mit dem ersten und dem zweiten Bauteil in Kontakt steht.

2. Anschlusseinrichtung nach Anspruch 1, **dadurch gekennzeichnet, dass** der wenigstens eine Nebenwiderstand teilweise in das Verbindungselement eingebettet ist.

3. Anschlusseinrichtung nach Anspruch 2, **dadurch gekennzeichnet, dass** das erste Bauteil und das zweite Bauteil jeweils als Ringteil ausgebildet sind.

4. Anschlusseinrichtung nach Anspruch 3, **dadurch gekennzeichnet, dass** der Nebenwiderstand als stabförmiges Element ausgebildet ist.

5. Anschlusseinrichtung nach einem der Ansprüche 3 oder 4, **dadurch gekennzeichnet, dass** das erste Bauteil und das zweite Bauteil erste Ausnehmungen zur teilweisen Aufnahme des Nebenwiderstands aufweisen.

6. Anschlusseinrichtung nach einem der Ansprüche 3 bis 5, **gekennzeichnet durch** eine Mehrzahl von Nebenwiderständen.

7. Anschlusseinrichtung nach einem der Ansprüche 3 bis 6, **dadurch gekennzeichnet, dass** das erste Bauteil und das zweite Bauteil zweite Ausnehmungen aufweisen, wobei das Verbindungselement Vorsprünge aufweist, wobei die Vorsprünge des Verbindungselements von den zweiten Ausnehmungen des ersten Bauteils und des zweiten Bauteils aufgenommen sind.

8. Anschlusseinrichtung nach einem der Ansprüche 3 bis 7, **gekennzeichnet durch** ein Durchgangsloch mit einem Gewinde, welches die Bauteile und das Verbindungselement vollständig durchdringt.

9. Anschlusseinrichtung nach einem der Ansprüche 3 bis 8, **dadurch gekennzeichnet, dass** das Verbindungselement als Spritzgussteil ausgebildet ist.

10. Anschlusseinrichtung nach einem der Ansprüche 3 bis 9, **gekennzeichnet durch** eine außenseitige elektrische Isolierung.

11. Anschlusseinrichtung nach Anspruch 10, **dadurch gekennzeichnet, dass** das Verbindungselement und die außenseitige Isolierung einstückig ausgebildet sind.

12. Batterieanordnung aufweisend eine Batterie, eine Anschlusseinrichtung gemäß einem der Ansprüche 1 bis 11 und einen Stromabnehmer, wobei die Batterie Anschlusspole bereitstellt, wobei die Anschlusseinrichtung zwischen einem der Anschlusspole und dem Stromabnehmer angeordnet ist und diese elektrisch miteinander verbindet.

13. Batterieanordnung nach einem der Ansprüche 12, **dadurch gekennzeichnet, dass** von der Anschlusseinrichtung nur das erste Bauteil mit einem der Anschlusspole in elektrischem Kontakt steht.

14. Batterieanordnung nach Anspruch 13, **dadurch gekennzeichnet, dass** der Stromabnehmer und die Anschlusseinrichtung mittels einer Schraube mit elektrisch isoliertem Schaft an einem der Anschlusspole befestigt sind.

15. Verwendung einer Anschlusseinrichtung nach einem der Ansprüche 1 bis 11, als Teil einer Messeinrichtung zur Bestimmung einer von einer Batterie, insbesondere einer Traktionsbatterie, abgegebenen Strommenge.

## Geänderte Patentansprüche

### Geänderte Patentansprüche gemäss Regel 137(2) EPÜ.

1. Anschlusseinrichtung für eine Batterie (2) zur Zwischenschaltung zwischen einen Batterieanschluss (3, 4) und einen an der Batterie (2) angeschlossenen Verbraucher, aufweisend ein elektrisch leitend ausgebildetes erstes Bauteil (18), ein elektrisch leitend ausgebildetes zweites Bauteil (19), wenigstens ein elektrisch leitend ausgebildeter Nebenwiderstand (25) und ein elektrisch isolierend ausgebildetes Verbindungselement (20), wobei die Bauteile unter Zwischenordnung des Verbindungselements (20) voneinander beabstandet angeordnet sind, wobei das Verbindungselement (20) zur mechanischen Verbindung der Bauteile mit dem ersten und dem zweiten Bauteil (18, 19) in Kontakt steht und wobei der Nebenwiderstand (25) zur elektrischen Verbindung der Bauteile (18, 19) mit dem ersten und dem zweiten Bauteil (18, 19) in Kontakt steht, wobei das erste Bauteil (18) und das zweite Bauteil (19) jeweils als Ringteil ausgebildet sind, **dadurch gekennzeichnet, dass** der Nebenwiderstand (25) als stabförmiges Element ausgebildet ist.

2. Anschlusseinrichtung nach Anspruch 1, **dadurch gekennzeichnet, dass** der wenigstens eine Nebenwiderstand (25) teilweise in das Verbindungselement eingebettet ist.

3. Anschlusseinrichtung nach Anspruch 1, **dadurch gekennzeichnet, dass** das erste Bauteil (18) und das zweite Bauteil (19) erste Ausnehmungen (26) zur teilweisen Aufnahme des Nebenwiderstands (25) aufweisen.

4. Anschlusseinrichtung nach Anspruch 1, **gekennzeichnet durch** eine Mehrzahl von Nebenwiderständen (25).

5. Anschlusseinrichtung nach Anspruch 1, **dadurch gekennzeichnet, dass** das erste Bauteil (18) und das zweite Bauteil (19) zweite Ausnehmungen (27) aufweisen, wobei das Verbindungselement (20) Vorsprünge (28) aufweist, wobei die Vorsprünge (28) des Verbindungselements (20) von den zweiten Ausnehmungen (27) des ersten Bauteils (18) und des zweiten Bauteils (19) aufgenommen sind.

6. Anschlusseinrichtung nach Anspruch 1, **gekennzeichnet durch** ein Durchgangsloch (29) mit einem Gewinde, welches die Bauteile und das Verbindungselement (20) vollständig durchdringt.

7. Anschlusseinrichtung nach Anspruch 1, **dadurch gekennzeichnet, dass** das Verbindungselement (20) als Spritzgussteil ausgebildet ist.

8. Anschlusseinrichtung nach Anspruch 1, **gekennzeichnet durch** eine außenseitige elektrische Isolierung.

9. Anschlusseinrichtung nach Anspruch 8, **dadurch gekennzeichnet, dass** das Verbindungselement (20) und die außenseitige Isolierung einstückig ausgebildet sind.

10. Batterieanordnung aufweisend eine Batterie, eine Anschlusseinrichtung gemäß einem der Ansprüche 1 bis 9 und einen Stromabnehmer, wobei die Batterie (2) Anschlusspole (3, 4) bereitstellt, wobei die Anschlusseinrichtung (17) zwischen einem der Anschlusspole (3, 4) und dem Stromabnehmer angeordnet ist und diese elektrisch miteinander verbindet.

11. Batterieanordnung nach einem der Ansprüche 10, **dadurch gekennzeichnet, dass** von der Anschlusseinrichtung (17) nur das erste Bauteil (18) mit einem der Anschlusspole (3, 4) in elektrischem Kontakt steht.

12. Batterieanordnung nach Anspruch 11, **dadurch gekennzeichnet, dass** der Stromabnehmer und die Anschlusseinrichtung (17) mittels einer Schraube (30) mit elektrisch isoliertem Schaft (48) an einem der Anschiusspole (3, 4) befestigt sind.

13. Verwendung einer Anschlusseinrichtung nach einem der Ansprüche 1 bis 9, als Teil einer Messeinrichtung zur Bestimmung einer von einer Batterie (2), insbesondere einer Traktionsbatterie, abgegebenen Strommenge.
